# FASCICULE DE BREVET EUROPEEN

(11) **EP 4 439 895 B1**
(45) Date de publication et mention de la délivrance du brevet: **20.08.2025**
(21) Numéro de dépôt: 24166787.2
(22) Date de dépôt: 27.03.2024
(51) Int. Cl.: H01H 9/54, H02H 3/02, H02H 7/26, H02H 3/24, H01H 83/10, H01H 83/12, H01H 83/22, H02H 3/08, H02H 3/10

(54) **DISPOSITIF DE PROTECTION**
SCHUTZSCHALTGERÄT
PROTECTION DEVICE

(30) Priorité: 28.03.2023 FR 2302957
(43) Date de publication de la demande: 02.10.2024
(73) Titulaire: SCHNEIDER ELECTRIC INDUSTRIES SAS, 92500 Rueil-Malmaison (FR)
(72) Inventeur: TIAN, Simon, 38330 Saint-Ismier (FR)
(74) Mandataire: Lavoix

(56) Documents cités:
- EP-A1- 0 209 765
- FR-A1- 2 147 841
- FR-A1- 3 116 391
- GB-A- 2 182 812

## Description

La présente invention concerne un dispositif de protection d'une installation électrique et un procédé de fonctionnement d'un tel dispositif de protection.

Une installation électrique d'un bâtiment comporte généralement un tableau électrique, reliant cette installation électrique à un réseau de distribution d'électricité collectif et comportant divers dispositifs de protection, de commande et de surveillance de l'installation électrique. Parmi les dispositifs de protection électrique, on connaît notamment un disjoncteur, qui vise à protéger l'installation électrique ou une personne vis-à-vis d'un défaut électrique d'un circuit électrique de l'installation, en ouvrant le circuit électrique. Par exemple, le disjoncteur est déclenché par une surcharge, un court-circuit ou un défaut électrique différentiel au sein de ce circuit.

De tels disjoncteurs comportent généralement une chambre de coupure configurée pour éteindre un arc électrique qui apparaît dans l'air entre les contacts électriques du disjoncteur lorsque les contacts électriques sont séparés suite à un déclenchement du disjoncteur. La chambre de coupure comporte typiquement un empilement de plaques métalliques superposées les unes au-dessus des autres pour allonger et éteindre l'arc électrique. Un ou plusieurs orifices ménagés dans le boîtier du disjoncteur permettent aux gaz de coupure d'être rejetés à l'extérieur du disjoncteur.

Toutefois, afin d'améliorer les performances de ces dispositifs de protection, il a été proposé de remplacer la chambre de coupure par un dispositif de coupure électronique comportant des interrupteurs de puissance à base de composants semi-conducteurs. De tels dispositifs de protection présentent une capacité de coupure élevée et permettent une coupure particulièrement rapide, réduisant ainsi considérablement l'arc de coupure. Un tel dispositif de protection pourvu d'un dispositif de coupure électronique comportant des interrupteurs de puissance à base de composants semi-conducteurs est par exemple connu du document FR 3 123 141 A1. GB2182812A décrit un dispositif pour alimenter en courant un circuit à une ou plusieurs phases, comprenant des moyens pour interrompre le courant en cas de défaut comme un cours circuit.

Toutefois, de tels dispositifs présentent des coûts de production supérieurs aux coûts de production de dispositifs de protection classiques.

Le but de l'invention est alors de proposer un dispositif de protection peu onéreux permettant une coupure particulièrement rapide et présentant une capacité de coupure élevée.

A cet effet, l'invention a pour objet un dispositif de protection d'une installation électrique selon la revendication 1. L'invention concerne également un procédé de fonctionnement d'un dispositif de protection selon la revendication 6.

Suivant d'autres aspects avantageux de l'invention, le dispositif de protection comprend une ou plusieurs des caractéristiques des revendications 2 à 5, prises isolément ou suivant toutes les combinaisons techniquement possibles.

Suivant d'autres aspects avantageux de l'invention, le procédé de fonctionnement comprend une ou plusieurs des caractéristiques des revendications 7 à 12, prises isolément ou suivant toutes les combinaisons techniquement possibles.

L'invention apparaîtra plus clairement à la lecture de la description qui va suivre, donnée uniquement à titre d'exemple non limitatif, et faite en référence aux dessins dans lesquels :
[Fig. 1] la figure 1 est une représentation schématique d'un dispositif de protection selon un mode de réalisation ;
[Fig. 2] la figure 2 est une représentation schématique du dispositif de protection selon le mode de réalisation illustrant un court-circuit ;
[Fig. 3] la figure 3 est une représentation graphique d'un exemple d'enchainement d'étapes d'un procédé de fonctionnement du dispositif de protection selon le mode de réalisation dans le cas d'un court-circuit ;
[Fig. 4] la figure 4 est une représentation schématique du dispositif de protection selon le mode de réalisation illustrant une surcharge ;
[Fig. 5] la figure 5 est une représentation graphique d'un exemple d'enchainement d'étapes du procédé de fonctionnement du dispositif de protection selon le mode de réalisation dans le cas d'une surcharge ;
[Fig. 6] la figure 6 est une représentation schématique du dispositif de protection selon le mode de réalisation illustrant un défaut différentiel ; et
[Fig. 7] la figure 7 est une représentation graphique d'un exemple d'enchainement d'étapes du procédé de fonctionnement du dispositif de protection selon le mode de réalisation dans le cas d'un défaut différentiel.

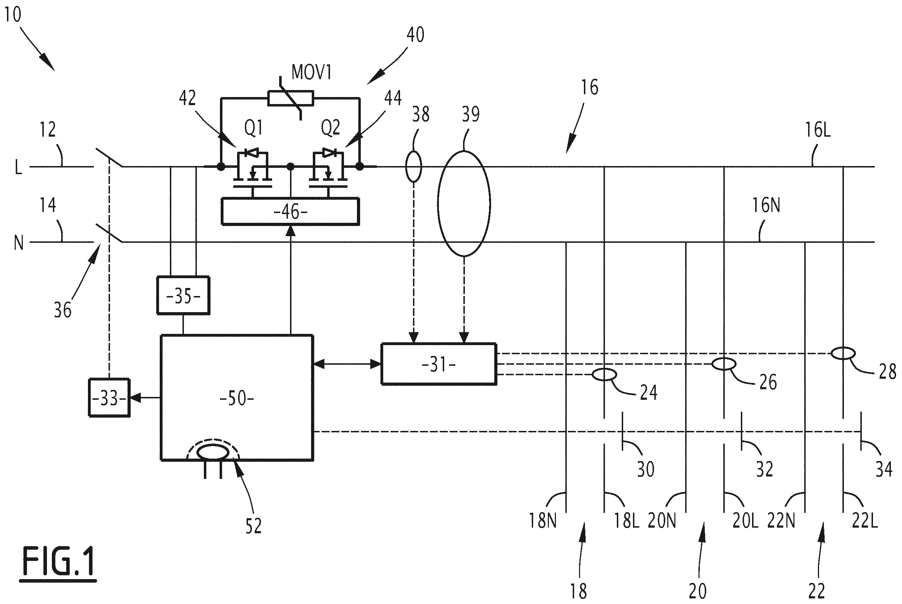

La présente demande concerne un dispositif de protection 10 d'une installation électrique ainsi qu'un procédé de fonctionnement d'un tel dispositif de protection 10. La figure 1 est une représentation schématique du mode de réalisation préféré du dispositif de protection 10.

Le dispositif de protection 10 comporte une paire de bornes d'entrée 12, 14, une ligne d'entrée 16 pourvue de deux conducteurs d'entrée 16L, 16N chacun relié à l'une parmi les bornes d'entrée 12, 14, une pluralité de lignes de sortie 18, 20, 22 branchées en parallèle sur la ligne d'entrée 16, chaque ligne de sortie 18, 20, 22 étant pourvue de deux conducteurs de sortie 18L, 18N, 20L, 20N, 22L, 22N, d'un dispositif de mesure de courant de sortie 24, 26, 28 et étant apte à alimenter une installation électrique aval, un dispositif de coupure électronique 40 comportant des interrupteurs de puissance 42, 44 à base de composants semi-conducteurs branchés en série entre la ligne d'entrée 16 et la ligne de sortie 18, 20, 22, une unité de commande 50 apte à piloter le dispositif de coupure électronique 40.

L'unité de commande 50 est en outre apte à recevoir un signal représentatif d'un courant de sortie de chaque ligne de sortie 18, 20, 22 mesuré par le dispositif de mesure de courant de sortie 24, 26, 28 de cette ligne de sortie 18, 20, 22. L'un parmi les conducteurs de sortie 18L, 18N, 20L, 20N, 22L, 22N de chaque ligne de sortie 18, 20, 22 est pourvu d'un interrupteur 30, 32, 34 pilotable par l'unité de commande 50 pour commuter l'interrupteur 30, 32, 34 entre une position ouverte et une position fermée et inversement.

Le dispositif de protection 10 selon la présente demande comporte au moins deux lignes de sortie 18, 20, 22 chacune apte à alimenter une installation électrique aval. Le dispositif de protection 10 selon le présent mode de réalisation comporte trois lignes de sortie 18, 20, 22 chacune apte à alimenter une installation électrique aval : une première ligne de sortie 18 apte à alimenter une première installation électrique aval, une deuxième ligne de sortie 20 apte à alimenter une deuxième installation électrique aval et une troisième ligne de sortie 22 apte à alimenter une troisième installation électrique aval.

Le dispositif de protection 10 peut en outre être pourvu de bornes de sortie chacune branchée à l'un parmi les conducteurs de sortie 18L, 18N, 20L, 20N, 22L, 22N.

L'interrupteur 30, 32, 34 de chaque ligne de sortie 18, 20, 22 est branché sur le conducteur de sortie 18L, 18N, 20L, 20N, 22L, 22N constituant le conducteur phase 18L, 20L, 22L de la ligne de sortie 18, 20, 22 et permet d'interrompre le courant dans le conducteur phase 18L, 20L, 22L. L'interrupteur 30, 32, 34 de chaque ligne de sortie 18, 20, 22 peut consister en un relai pilotable par l'unité de commande 50 pour commuter le relai entre une position ouverte et une position fermée et inversement. De façon alternative, l'interrupteur 30, 32, 34 de chaque ligne de sortie 18, 20, 22 peut consister en un sectionneur pilotable par l'unité de commande 50 pour commuter le sectionneur entre une position ouverte et une position fermée et inversement.

Selon une possibilité, les conducteurs d'entrée 16L, 16N peuvent comporter des contacts électriques séparables 36 agencés entre la paire de bornes d'entrée 12, 14 et le dispositif de coupure électronique 40, le dispositif de protection 10 comprenant en outre un actionneur 33 pilotable par l'unité de commande 50 et apte à commuter les contacts électriques séparables 36 entre une position fermée et une position ouverte et inversement.

Le dispositif de protection 10 peut comprendre une manette. La manette peut être adaptée pour envoyer une commande d'ouverture des contacts électriques séparables 36 à l'unité de commande 50 suite à une action d'un utilisateur sur la manette. Suite à la réception de la commande d'ouverture des contacts électriques séparables 36 par l'unité de commande 50, l'unité de commande 50 peut ouvrir le dispositif de coupure électronique 40 pour couper le courant dans les installations électriques aval. Ensuite, l'unité de commande 50 peut en outre ouvrir les contacts électriques séparables 36 pour sectionnement.

La ligne d'entrée 16 peut être pourvue d'un dispositif de mesure de courant d'entrée 38, l'unité de commande 50 étant en outre apte à recevoir un signal représentatif d'un courant d'entrée mesuré par le dispositif de mesure de courant d'entrée 38.

De façon additionnelle ou alternative, la ligne d'entrée 16 peut être pourvue d'un dispositif de mesure de courant différentiel 39, l'unité de commande 50 étant en outre apte à recevoir un signal représentatif d'un courant différentiel mesuré par le dispositif de mesure de courant différentiel 39.

La ligne d'entrée 16 est pourvue d'un dispositif de mesure de tension, l'unité de commande 50 étant en outre apte à recevoir un signal représentatif d'une tension mesurée par le dispositif de mesure de tension.

Tel que représenté dans la figure 1, le dispositif de protection 10 peut en outre comporter un module d'alimentation 35 apte à alimenter l'unité de commande 50 en énergie électrique. Le module d'alimentation 35 peut être, d'une part, relié à l'unité de commande 50 et, d'autre part, relié à la ligne d'entrée, de préférence entre les contacts électriques séparables 36 et le dispositif de coupure électronique 40. Ainsi, une ouverture des contacts séparables 36 permet un isolement galvanique du dispositif de coupure électronique 40.

De façon alternative, le module d'alimentation 35 peut être relié à la ligne d'entrée en amont des contacts électriques séparables 36, par exemple entre les contacts électriques séparables 36 et les bornes d'entrée 12, 14. Ainsi, une alimentation de l'unité de commande 50 peut être assurée même en position ouverte des contacts électriques séparables 36. Ceci est particulièrement avantageux lorsque le dispositif de protection 10 comporte un module d'affichage par exemple pourvu d'une pluralité de diodes électroluminescentes et/ou d'un écran à cristaux liquides affichant une information à un utilisateur telle qu'une nature du défaut ayant provoqué la coupure.

Le dispositif de mesure de tension peut faire partie intégrante du module d'alimentation 35.

Le dispositif de protection 10 peut en outre comporter un circuit de contrôle 46 apte à contrôler l'ouverture et/ou la fermeture des interrupteurs de puissance 42, 44 à base de composants semi-conducteurs du dispositif de coupure électronique 40 suite à la réception d'une commande d'ouverture ou de fermeture provenant de l'unité de commande 50.

Le dispositif de protection 10 peut en outre comporter un convertisseur analogique-numérique 31 relié, d'une part, aux dispositifs de mesure de courant de sortie 24, 26, 28, au dispositif de mesure de courant d'entrée 38 et/ou au dispositif de mesure de courant différentiel 39 et, d'autre part, à l'unité de commande 50. Le convertisseur analogique-numérique 31 est apte à convertir un signal analogique provenant des dispositifs de mesure de courant de sortie 24, 26, 28 en un signal numérique représentatif d'un courant de sortie mesuré par les dispositifs de mesure de courant de sortie 24, 26, 28. Le convertisseur analogique-numérique 31 est en outre apte à convertir un signal analogique provenant du dispositif de mesure de courant d'entrée 38 en un signal numérique représentatif d'un courant d'entrée mesuré par le dispositif de mesure de courant d'entrée 38. Le convertisseur analogique-numérique 31 est aussi apte à convertir un signal analogique provenant du dispositif de mesure de courant différentiel 39 en un signal numérique représentatif d'un courant différentiel mesuré par le dispositif de mesure de courant différentiel 39.

L'unité de commande 50 comporte une unité de calcul et une mémoire et peut en outre être pourvue d'une interface de communication 52.

L'unité de commande 50 est apte à déterminer si les signaux représentatifs du courant de sortie de chaque ligne de sortie 18, 20, 22 correspondent à un court-circuit intervenant dans une des installations électriques aval alimentées par l'une parmi les lignes de sortie 18, 20, 22 et/ou à une surcharge intervenant dans une des installations électriques aval alimentées par l'une parmi les lignes de sortie 18, 20, 22.

L'unité de commande 50 peut en outre être apte à déterminer si le signal représentatif du courant différentiel correspond à un départ différentiel intervenant dans une des installations électriques aval alimentées par l'une parmi les lignes de sortie 18, 20, 22.

Selon une possibilité, l'unité de commande 50 est apte à déterminer si le signal représentatif de la tension correspond à une tension inférieure ou supérieure à une tension minimale de bon fonctionnement du dispositif de coupure électronique 40 et si le signal représentatif de la tension correspond à une tension supérieure ou inférieure à une tension maximale de bon fonctionnement du dispositif de coupure électronique 40 et éventuellement à une tension maximale de bon fonctionnement de l'une des installations électriques aval.

Le procédé de fonctionnement du dispositif de protection 10 comporte les étapes successives suivantes :
a. réception par l'unité de commande 50, pour chaque ligne de sortie 18, 20, 22, d'un signal représentatif d'un courant de sortie provenant du dispositif de mesure de courant de sortie 24, 26, 28 de la ligne de sortie 18, 20, 22 ;
b. détermination 120 par l'unité de commande 50 si les signaux représentatifs du courant de sortie de chaque ligne de sortie 18, 20, 22 correspondent à un court-circuit intervenant dans une des installations électriques aval alimentées par l'une parmi les lignes de sortie 18, 20, 22 ;
c. lorsqu'un court-circuit a été déterminé dans l'une des installations électriques aval :
   i. ouverture 140 du dispositif de coupure électronique 40 ;
   ii. ouverture 150 de l'interrupteur 30, 32, 34 de la ligne de sortie 18, 20, 22 dans laquelle le court-circuit a été déterminé ; et
   iii. fermeture 160 du dispositif de coupure électronique 40.

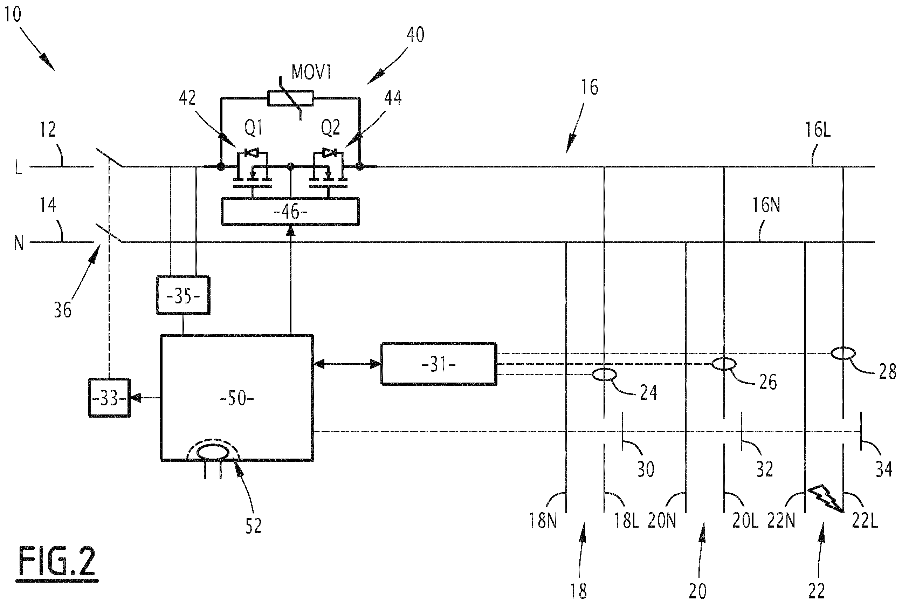

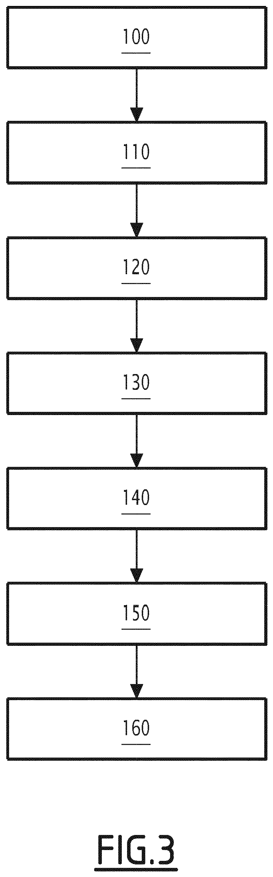

Lorsqu'un court-circuit 100 intervient par exemple dans la troisième installation électrique aval ou la troisième ligne de sortie 22, tel qu'illustré par la figure 2 et la figure 3, le dispositif de mesure de courant de sortie 28 de la troisième ligne de sortie 22 mesure 110 un courant de court-circuit dans la troisième ligne de sortie 22.

L'unité de commande 50 reçoit ensuite les signaux représentatifs du courant de sortie de chaque ligne de sortie 18, 20, 22, notamment le signal représentatif du courant de sortie de la troisième ligne de sortie 22, de préférence de la part du convertisseur analogique-numérique 31. L'unité de commande 50 détermine 120 par la suite que le signal représentatif du courant de sortie de la troisième ligne de sortie 22 correspond à un courant de court-circuit et transmet 130 une commande d'ouverture au circuit de contrôle 46 du dispositif de coupure électronique 40 pour ouvrir 140 le dispositif de coupure électronique 40. Suite à l'ouverture du dispositif de coupure électronique 40, l'unité de commande 50 commande l'ouverture 150 de l'interrupteur 34 de la troisième ligne de sortie 22. De préférence, l'unité de commande 50 commande l'ouverture 150 de l'interrupteur 34 de la troisième ligne de sortie 22 lorsque le signal représentatif du courant de sortie de la troisième ligne de sortie 18, 20, 22 correspond à un passage à zéro du courant de sortie de la troisième ligne de sortie 22. Suite à l'ouverture de l'interrupteur 34 de la troisième ligne de sortie 22, l'unité de commande 50 commande la fermeture160 du dispositif de coupure électronique 40.

De préférence, les étapes d'ouverture 140 du dispositif de coupure électronique 40, d'ouverture 150 de l'interrupteur 30, 32, 34 et de fermeture 160 du dispositif de coupure électronique 40 sont exécutées dans un espace de temps inférieur à 10 millisecondes.

Le procédé de fonctionnement peut en outre comporter les étapes successives suivantes :
a. détermination 220 par l'unité de commande 50 si les signaux représentatifs du courant de sortie de chaque ligne de sortie 18, 20, 22 correspondent à une surcharge intervenant dans une des installations électriques aval alimentées par l'une parmi les lignes de sortie 18, 20, 22 ;
b. lorsqu'une surcharge a été déterminée dans l'une des installations électriques aval :
   i. ouverture 230 de l'interrupteur 30, 32, 34 de la ligne de sortie 18, 20, 22 dans laquelle la surcharge a été déterminée.

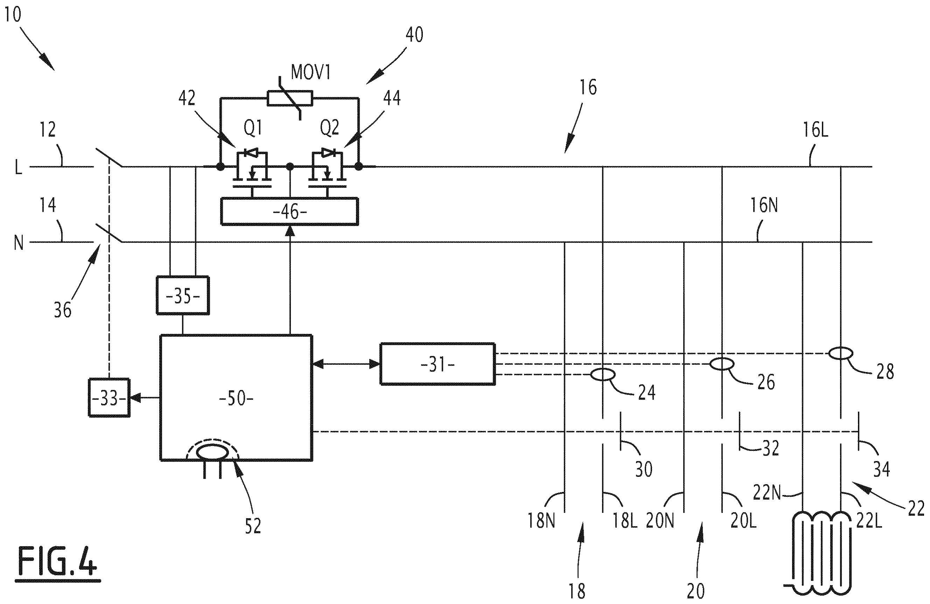

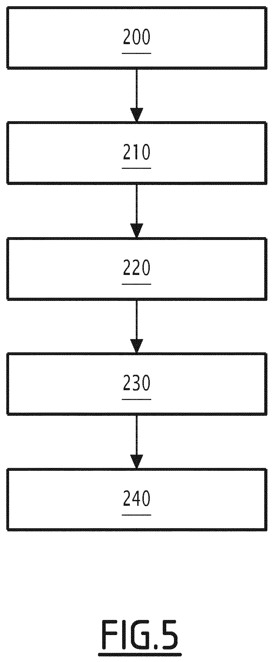

Lorsqu'une surcharge 200 intervient par exemple dans la troisième installation électrique aval ou la troisième ligne de sortie 22, tel qu'illustré par la figure 4 et la figure 5, le dispositif de mesure de courant de sortie 28 de la troisième ligne de sortie 22 mesure 110 un courant de surcharge dans la troisième ligne de sortie 22.

L'unité de commande 50 reçoit ensuite les signaux représentatifs du courant de sortie de chaque ligne de sortie 18, 20, 22, notamment le signal représentatif du courant de sortie de la troisième ligne de sortie 22, de préférence de la part du convertisseur analogique-numérique 31. L'unité de commande 50 détermine 220 par la suite que le signal représentatif du courant de sortie de la troisième ligne de sortie 22 correspond à un courant de surcharge et ouvre 230 l'interrupteur 34 de la troisième ligne de sortie 22. De préférence, l'unité de commande 50 commande l'ouverture 230 de l'interrupteur 34 de la troisième ligne de sortie 22 lorsque le signal représentatif du courant de sortie de la troisième ligne de sortie 18, 20, 22 correspond à un passage à zéro du courant de sortie de la troisième ligne de sortie 22.

Dans le cas de l'apparition d'un court-circuit ou d'une surcharge dans l'une des installations électriques aval, l'installation électrique aval dans laquelle le court-circuit ou la surcharge est intervenu(e) est protégée, les autres installations électriques non affectées par le court-circuit ou la surcharge restant alimentées avec un temps d'interruption inférieur à 10 millisecondes.

Selon une possibilité, un seuil de courant peut être défini pour chaque ligne de sortie 18, 20, 22, une surcharge dans l'une parmi les lignes de sortie 18, 20, 22 étant déterminée lorsque le signal représentatif du courant de sortie de cette ligne de sortie 18, 20, 22 correspond à un courant dont l'intensité dépasse le seuil de courant défini pour cette ligne de sortie 18, 20, 22. Le seuil de courant défini pour chaque ligne de sortie 18, 20, 22 peut par exemple être stocké dans la mémoire de l'unité de commande 50.

Le seuil de courant défini pour chaque ligne de sortie 18, 20, 22 peut par exemple être défini par un utilisateur au travers d'une interface utilisateur en lien de communication avec l'interface de communication 52 de l'unité de commande 50. Le seuil de courant défini pour chaque ligne de sortie 18, 20, 22 peut être transmis depuis l'interface utilisateur vers l'interface de communication 52 de l'unité de commande 50 en passant par le lien de communication puis stocké dans la mémoire de l'unité de commande 50.

De façon alternative, le seuil de courant défini pour chaque ligne de sortie 18, 20, 22 peut être défini par un logiciel exécuté sur un serveur distant en lien de communication avec l'interface de communication 52 de l'unité de commande 50 par exemple. Le seuil de courant défini pour chaque ligne de sortie 18, 20, 22 peut être transmis depuis le serveur distant vers l'interface de communication 52 de l'unité de commande 50 en passant par le lien de communication puis stocké dans la mémoire de l'unité de commande 50.

Selon une alternative, une courbe de protection de charge adaptée à l'installation électrique aval reliée à la ligne de sortie 18, 20, 22 peut être respectivement définie pour chaque ligne de sortie 18, 20, 22, une surcharge dans l'une parmi les lignes de sortie 18, 20, 22 étant déterminée lorsque le signal représentatif du courant de sortie de cette ligne de sortie 18, 20, 22 correspond à une situation de défaut selon la courbe de protection définie pour l'installation électrique aval reliée à cette ligne de sortie 18, 20, 22. La courbe de protection adaptée à l'installation électrique aval peut par exemple être stockée dans la mémoire de l'unité de commande 50.

La courbe de protection adaptée à l'installation électrique aval reliée à la ligne de sortie 18, 20, 22 peut par exemple être définie par un utilisateur au travers d'une interface utilisateur en lien de communication avec l'interface de communication 52 de l'unité de commande 50. La courbe de protection adaptée peut être transmise depuis l'interface utilisateur vers l'interface de communication 52 de l'unité de commande 50 en passant par le lien de communication puis stocké dans la mémoire de l'unité de commande 50.

Le procédé de fonctionnement peut en outre comporter les étapes successives suivantes :
a. réception par l'unité de commande 50 d'un signal représentatif d'un courant différentiel provenant du dispositif de mesure de courant différentiel 39 ;
b. détermination 320 par l'unité de commande 50 si le signal représentatif du courant différentiel correspond à un départ différentiel intervenant dans une des installations électriques aval alimentées par l'une parmi les lignes de sortie 18, 20, 22 ;
c. lorsqu'un départ différentiel a été déterminé dans l'une des installations électriques aval :
   i. ouverture 330 du dispositif de coupure électronique 40 ; et
   ii. ouverture 340 des contacts électriques séparables 36.

Le départ différentiel peut par exemple être le résultat de l'apparition d'un courant de fuite dans une des installations électriques aval ou le résultat de l'apparition d'un défaut d'arc à la terre dans une des installations électriques aval.

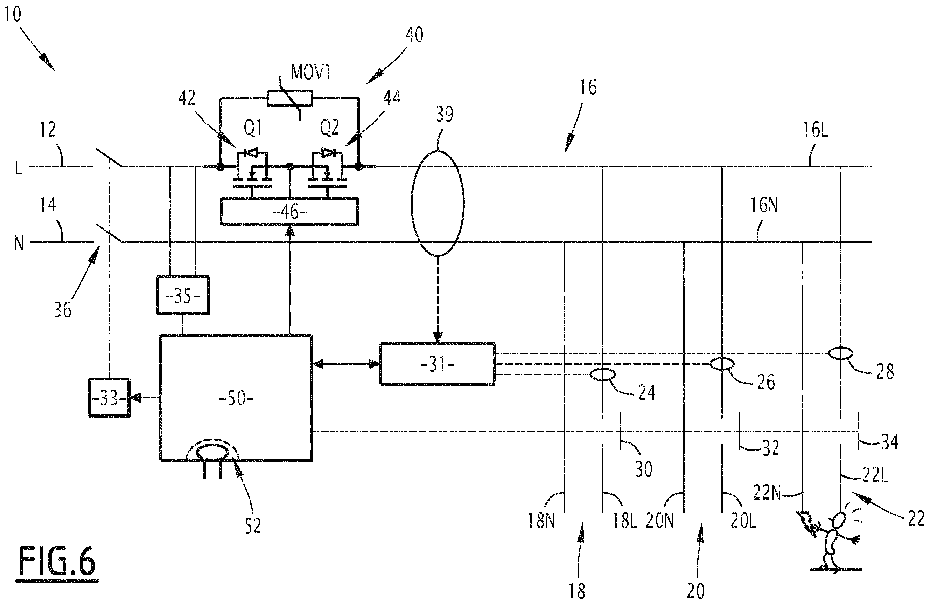

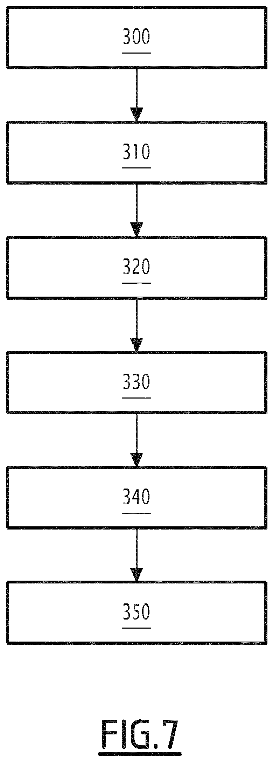

Lorsqu'un départ différentiel 300 intervient par exemple dans la troisième installation électrique aval ou la troisième ligne de sortie 22, tel qu'illustré par la figure 6 et la figure 7, le dispositif de mesure de courant différentiel 39 mesure 310 un courant différentiel correspondant à un départ différentiel dans une des lignes de sortie 18, 20, 22.

L'unité de commande 50 reçoit ensuite un signal représentatif d'un courant différentiel de préférence de la part du convertisseur analogique-numérique 31. L'unité de commande 50 détermine 320 par la suite que le signal représentatif du courant différentiel correspond à un départ différentiel intervenant dans une des installations électriques aval alimentées par l'une parmi les lignes de sortie 18, 20, 22 et commande l'ouverture 330 du dispositif de coupure électronique 40. Ensuite, l'unité de commande 50 commande l'ouverture 340 des contacts électriques séparables 36.

Le procédé de fonctionnement comporte en outre les étapes successives suivantes :
a. réception par l'unité de commande 50 d'un signal représentatif d'une tension provenant du dispositif de mesure de tension;
b. détermination par l'unité de commande 50 si le signal représentatif de la tension correspond à une tension inférieure à une tension minimale de bon fonctionnement du dispositif de coupure électronique 40 ;
c. lorsqu'une tension inférieure à la tension minimale de bon fonctionnement du dispositif de coupure électronique 40 a été déterminée :
   i. ouverture du dispositif de coupure électronique 40.
      Le procédé de fonctionnement peut ensuite comporter les étapes successives suivantes :
   ii. ouverture de l'interrupteur 30, 32, 34 de chaque ligne de sortie 18, 20, 22 ;
d. détermination par l'unité de commande 50 si le signal représentatif de la tension correspond à une tension supérieure à la tension minimale de bon fonctionnement du dispositif de coupure électronique 40 ;
e. lorsqu'une tension supérieure à la tension minimale de bon fonctionnement du dispositif de coupure électronique 40 a été déterminée :
   i. fermeture du dispositif de coupure électronique 40 ; et
   ii. fermeture de l'interrupteur 30, 32, 34 de chaque ligne de sortie 18, 20, 22.

Si la tension mesurée dépasse la tension minimale de bon fonctionnement, par exemple une tension de 100 V, le dispositif de coupure électronique 40 est alimenté et la protection des installations électriques aval est assurée.

Si la tension mesurée est en-dessous de la tension minimale de bon fonctionnement, le dispositif de coupure électronique 40 est ouvert pour couper le courant dans les installations électriques aval et chaque interrupteur 30, 32, 34 est ouvert pour l'isolement galvanique des installations électriques aval. La tension mesurée étant trop faible, les charges ne devraient pas non plus être alimentées (protection contre les sous-tensions).

Ainsi, puisque le bon fonctionnement du dispositif de coupure électronique 40 dépend de la présence d'une tension minimale de fonctionnement, lorsque la tension est à zéro, par exemple en cas de rupture du conducteur neutre, la protection ne peut pas être assurée par le dispositif de coupure électronique 40, même au cas où une tension persiste sur le conducteur phase.

Quand la tension mesurée revient à un niveau normal, le dispositif de coupure électronique 40 peut être à nouveau fermé ainsi que les interrupteurs 30, 32, 34 pour réalimenter les installations électriques aval. Et la protection des installations électriques aval est ainsi à nouveau assurée.

Ce mode de fonctionnement est reconnu par la classification 4.1.5 dans la norme IEC61008/9.

Le procédé de fonctionnement comporte en outre les étapes successives suivantes :
a. réception par l'unité de commande 50 d'un signal représentatif d'une tension provenant du dispositif de mesure de tension;
b. détermination par l'unité de commande 50 si le signal représentatif de la tension correspond à une tension supérieure à une tension maximale de bon fonctionnement du dispositif de coupure électronique 40 ;
c. lorsqu'une tension supérieure à la tension maximale de bon fonctionnement du dispositif de coupure électronique 40 a été déterminée :
   i. ouverture du dispositif de coupure électronique 40 ; et
   ii. ouverture de l'interrupteur 30, 32, 34 de chaque ligne de sortie 18, 20, 22.
   Le procédé de fonctionnement peut ensuite comporter les étapes successives suivantes :
d. détermination par l'unité de commande 50 si le signal représentatif de la tension correspond à une tension inférieure à la tension maximale de bon fonctionnement du dispositif de coupure électronique 40 ;
e. lorsqu'une tension inférieure à la tension maximale de bon fonctionnement du dispositif de coupure électronique 40 a été déterminée :
   i. fermeture du dispositif de coupure électronique 40 ; et
   ii. fermeture de l'interrupteur 30, 32, 34 de chaque ligne de sortie 18, 20, 22.

Le dispositif de coupure électronique 40 avec des composants semi-conducteurs étant en général très sensible aux surtensions, ces étapes additionnelles de procédé permettent d'assurer la fiabilité du dispositif de protection 10.

Lorsque la surtension mesurée est de nature temporaire, l'ouverture du dispositif de coupure électronique 40 et des interrupteurs 30, 32, 34 est effectuée jusqu'à la disparition de la surtension pour l'isolement galvanique des installations électriques aval et du dispositif de coupure électronique 40 et pour la protection du dispositif de coupure électronique 40 et des installations électriques aval.

Lorsque la surtension mesurée persiste, par exemple pendant une durée supérieure à 10 minutes, le procédé peut comporter l'ouverture des contacts électriques séparables 36 pour sectionnement.

Le procédé peut en outre comprendre une étape de calcul d'une consommation électrique d'au moins une parmi les installations électriques en fonction de la tension mesurée et du courant de sortie mesuré pour la ligne de sortie 18, 20, 22 branchée à cette installation électrique par l'unité de commande 50. Cette étape permet à un utilisateur et/ou à l'unité de commande du dispositif de protection 10 de surveiller la consommation électrique cette installation électrique.

Le procédé peut en outre comprendre une étape de mise hors tension de l'une des installations électriques aval suite à la réception d'une commande d'ouverture à distance de l'interrupteur 30, 32, 34 de la ligne de sortie 18, 20, 22 branchée à cette installation électrique par l'unité de commande 50. La commande d'ouverture à distance de l'interrupteur 30, 32, 34 de la ligne de sortie 18, 20, 22 peut par exemple être envoyée vers l'unité de commande 50 au travers de son interface de communication 52. La commande d'ouverture à distance de l'interrupteur 30, 32, 34 de la ligne de sortie 18, 20, 22 peut préalablement être renseignée par un utilisateur dans une interface utilisateur qui est en lien de communication avec l'interface de communication 52 de l'unité de commande 50.

L'étape de mise hors tension de l'une des installations électriques aval peut être effectuée en ouvrant l'interrupteur 30, 32, 34 de la ligne de sortie 18, 20, 22 branchée à cette installation électrique aval au passage à zéro du courant traversant cette ligne de sortie 18, 20, 22. De façon alternative, l'étape de mise hors tension de l'une des installations électriques aval peut être effectuée en ouvrant d'abord le dispositif de coupure électronique 40 et ensuite l'interrupteur 30, 32, 34 de la ligne de sortie 18, 20, 22 branchée à cette installation électrique aval.

Le procédé peut en outre comprendre une étape de mise en tension de l'une des installations électriques aval suite à la réception d'une commande de fermeture de l'interrupteur 30, 32, 34 de la ligne de sortie 18, 20, 22 branchée à cette installation électrique par l'unité de commande 50.

La commande de fermeture de l'interrupteur 30, 32, 34 de la ligne de sortie 18, 20, 22 peut par exemple être envoyée vers l'unité de commande 50 au travers de son interface de communication 52. La commande de fermeture de l'interrupteur 30, 32, 34 de la ligne de sortie 18, 20, 22 peut préalablement être renseignée par un utilisateur dans une interface utilisateur qui est en lien de communication avec l'interface de communication 52 de l'unité de commande 50.

L'étape de mise en tension de l'une des installations électriques aval peut être effectuée en fermant l'interrupteur 30, 32, 34 de la ligne de sortie 18, 20, 22 branchée à cette installation électrique aval au passage à zéro de la tension présente sur cette ligne de sortie 18, 20, 22. De façon alternative, l'étape de mise en tension de l'une des installations électriques aval peut être effectuée en ouvrant d'abord le dispositif de coupure électronique 40, en fermant ensuite l'interrupteur 30, 32, 34 de la ligne de sortie 18, 20, 22 branchée à cette installation électrique aval et en refermant à la suite le dispositif de coupure électronique 40.

Le procédé de fonctionnement peut en outre comporter les étapes successives suivantes :
a. définition d'un seuil de courant de délestage ;
b. attribution d'un degré de priorité de chaque ligne de sortie 18, 20, 22 ;
c. lorsque la somme des courants de chaque ligne de sortie 18, 20, 22 correspondant au signal représentatif du courant de sortie de cette ligne dépasse le seuil de courant de délestage ou lorsque le courant d'entrée correspondant au signal représentatif du courant d'entrée dépasse le seuil de courant de délestage :
   i. ouverture de l'interrupteur 30, 32, 34 de la ligne de sortie 18, 20, 22 à laquelle a été attribué le degré de priorité le plus faible parmi les degrés de priorités de chaque ligne de sortie 18, 20, 22.

Le seuil de courant de délestage peut par exemple être envoyé vers l'unité de commande 50 au travers de son interface de communication 52. Le seuil de courant de délestage peut préalablement être renseigné par un utilisateur dans une interface utilisateur qui est en lien de communication avec l'interface de communication 52 de l'unité de commande 50. De façon alternative, le seuil de courant de délestage peut par exemple être imposé par un accord avec un fournisseur d'électricité pendant certaines plages horaires prédéfinies. De façon alternative, le seuil de courant de délestage peut correspondre à un calibre du dispositif de protection 10.

Grâce au dispositif de coupure électronique 40, le dispositif de protection 10 et le procédé de fonctionnement du dispositif de protection 10 permettent une interruption rapide du courant en cas de court-circuit minimisant l'arc de coupure, l'interrupteur 30, 32, 34 de la ligne de sortie 18, 20, 22 correspondant à l'installation électrique aval dans laquelle le court-circuit est intervenu étant ouvert pendant la brève période pendant laquelle le dispositif de coupure électronique 40 est ouvert. Dans le cas de l'apparition d'un court-circuit il peut être renoncé à l'attente du passage à zéro du courant avant l'ouverture de l'interrupteur 30, 32, 34 de la ligne de sortie 18, 20, 22 correspondant à l'installation électrique aval dans laquelle le court-circuit est intervenu.

Le dispositif de protection 10 et le procédé de fonctionnement du dispositif de protection 10 selon la présente demande permettent à plusieurs installations électriques aval de bénéficier des performances du dispositif de coupure électronique 40 sans nécessiter un dispositif de coupure électronique pour chaque ligne de sortie. Le dispositif de protection 10 et le procédé de fonctionnement du dispositif de protection 10 selon la présente demande permettent en outre d'être configurés par une mise à jour d'un logiciel exécuté par l'unité de commande 50.

Le dispositif de protection 10 et le procédé de fonctionnement du dispositif de protection 10 selon la présente demande présentent comme autre avantage de rendre possible l'ajout de nouvelles fonctions, telles que des nouvelles fonctions de protection, de continuité de service, de configuration à distance, de maintenance préventive et/ou de gestion des charges, pour une pluralité d'installations électriques aval.

## Revendications

1. Dispositif de protection d'une installation électrique, comprenant une paire de bornes d'entrée (12, 14), une ligne d'entrée (16) pourvue de deux conducteurs d'entrée (16L, 16N) chacun relié à l'une parmi les bornes d'entrée (12, 14), au moins une ligne de sortie (18, 20, 22) branchée sur la ligne d'entrée (16), pourvue de deux conducteurs de sortie (18L, 18N, 20L, 20N, 22L, 22N) et apte à alimenter une installation électrique aval, un dispositif de coupure électronique (40) comportant des interrupteurs de puissance (42, 44) à base de composants semi-conducteurs branchés en série entre la ligne d'entrée (16) et la ligne de sortie (18, 20, 22), et une unité de commande (50) apte à piloter le dispositif de coupure électronique (40), le dispositif de protection comporte une pluralité de lignes de sortie (18, 20, 22) branchées en parallèle sur la ligne d'entrée (16), chaque ligne de sortie (18, 20, 22) étant pourvue de deux conducteurs de sortie (18L, 18N, 20L, 20N, 22L, 22N), d'un dispositif de mesure de courant de sortie (24, 26, 28) et étant apte à alimenter une installation électrique aval, l'unité de commande (50) étant en outre apte à recevoir un signal représentatif d'un courant de sortie de chaque ligne de sortie (18, 20, 22) mesuré par le dispositif de mesure de courant de sortie (24, 26, 28) de cette ligne de sortie (18, 20, 22), et l'un parmi les conducteurs de sortie (18L, 18N, 20L, 20N, 22L, 22N) de chaque ligne de sortie (18, 20, 22) est pourvu d'un interrupteur (30, 32, 34) pilotable par l'unité de commande (50) pour commuter l'interrupteur (30, 32, 34) entre une position ouverte et une position fermée et inversement,
**caractérisé en ce que** la ligne d'entrée (16) est pourvue d'un dispositif de mesure de tension,
l'unité de commande (50) étant en outre apte à recevoir un signal représentatif d'une tension mesurée par le dispositif de mesure de tension,
l'unité de commande (50) est configurée pour déterminer si le signal représentatif de la tension correspond à une tension inférieure à une tension minimale de bon fonctionnement du dispositif de coupure électronique (40), ou à une tension supérieure à une tension maximale de bon fonctionnement du dispositif de coupure électronique (40),
et le dispositif de coupure électronique (40) et l'interrupteur (30, 32, 34) de chaque ligne de sortie (18, 20, 22) sont configurés pour s'ouvrir lorsqu'une tension inférieure à la tension minimale de bon fonctionnement du dispositif de coupure électronique (40) a été déterminée ou lorsqu'une tension supérieure à la tension maximale de bon fonctionnement du dispositif de coupure électronique (40) a été déterminée.

2. Dispositif de protection selon la revendication 1, **caractérisé en ce que** l'interrupteur (30, 32, 34) de chaque ligne de sortie (18, 20, 22) consiste en un relai pilotable par l'unité de commande (50) pour commuter le relai entre une position ouverte et une position fermée et inversement.

3. Dispositif de protection selon l'une quelconque des revendications 1 ou 2, **caractérisé en ce que** chaque conducteur d'entrée (16L, 16N) comporte des contacts électriques séparables (36) agencés entre la paire de bornes d'entrée (12, 14) et le dispositif de coupure électronique (40), le dispositif de protection comprenant en outre un actionneur pilotable par l'unité de commande (50) et apte à commuter les contacts électriques séparables (36) entre une position fermée et une position ouverte et inversement.

4. Dispositif de protection selon l'une quelconque des revendications 1 à 3, **caractérisé en ce que** la ligne d'entrée (16) est pourvue d'un dispositif de mesure de courant d'entrée (38) et/ou d'un dispositif de mesure de courant différentiel (39), l'unité de commande (50) étant en outre apte à recevoir un signal représentatif d'un courant d'entrée mesuré par le dispositif de mesure de courant d'entrée (38) et/ou apte à recevoir un signal représentatif d'un courant différentiel mesuré par le dispositif de mesure de courant différentiel (39).

5. Dispositif de protection selon l'un quelconque des revendications 1 à 4, **caractérisé en ce que** l'unité de commande (50) est configurée pour :
- recevoir, pour chaque ligne de sortie (18, 20, 22), un signal représentatif d'un courant de sortie provenant du dispositif de mesure de courant de sortie (24, 26, 28) de la ligne de sortie (18, 20, 22),
- déterminer (120) si les signaux représentatifs du courant de sortie de chaque ligne de sortie (18, 20, 22) correspondent à un court-circuit intervenant dans une des installations électriques aval alimentées par l'une parmi les lignes de sortie (18, 20, 22), et,
- lorsqu'un court-circuit a été déterminé dans l'une des installations électriques aval :
∘ transmettre (130) une commande d'ouverture au circuit de contrôle (46) du dispositif de coupure électronique (40) pour ouvrir (140) le dispositif de coupure électronique (40),
∘ commander l'ouverture (150) de l'interrupteur (30, 32, 34) de la ligne de sortie (18, 20, 22) dans laquelle le court-circuit a été déterminé, et
∘ - commander la fermeture (160) du dispositif de coupure électronique (40).

6. Procédé de fonctionnement d'un dispositif de protection selon l'une quelconque des revendications 1 à 5, comportant les étapes successives suivantes :
a. réception par l'unité de commande (50), pour chaque ligne de sortie (18, 20, 22), d'un signal représentatif d'un courant de sortie provenant du dispositif de mesure de courant de sortie (24, 26, 28) de la ligne de sortie (18, 20, 22) ;
b. détermination (120) par l'unité de commande (50) si les signaux représentatifs du courant de sortie de chaque ligne de sortie (18, 20, 22) correspondent à un court-circuit intervenant dans une des installations électriques aval alimentées par l'une parmi les lignes de sortie (18, 20, 22) ;
c. lorsqu'un court-circuit a été déterminé dans l'une des installations électriques aval :
i. ouverture (140) du dispositif de coupure électronique (40) ;
ii. ouverture (150) de l'interrupteur (30, 32, 34) de la ligne de sortie (18, 20, 22) dans laquelle le court-circuit a été déterminé ; et
iii. fermeture (160) du dispositif de coupure électronique (40),
**caractérisé en ce qu'**il comporte en outre les étapes suivantes :
a. réception par l'unité de commande (50) d'un signal représentatif d'une tension provenant du dispositif de mesure de tension;
b. détermination par l'unité de commande (50) si le signal représentatif de la tension correspond à une tension inférieure à une tension minimale de bon fonctionnement du dispositif de coupure électronique (40) ou à une tension supérieure à une tension maximale de bon fonctionnement du dispositif de coupure électronique (40) ;
c. lorsqu'une tension inférieure à la tension minimale de bon fonctionnement du dispositif de coupure électronique (40), ou une tension supérieure à la tension maximale de bon fonctionnement du dispositif de coupure électronique (40) a été déterminée :
i. ouverture du dispositif de coupure électronique (40) ; et
ii. ouverture de l'interrupteur (30, 32, 34) de chaque ligne de sortie (18, 20, 22).

7. Procédé de fonctionnement selon la revendication 6, **caractérisé par** les étapes successives suivantes :
a. détermination (220) par l'unité de commande (50) si les signaux représentatifs du courant de sortie de chaque ligne de sortie (18, 20, 22) correspondent à une surcharge intervenant dans une des installations électriques aval alimentées par l'une parmi les lignes de sortie (18, 20, 22) ;
b. lorsqu'une surcharge a été déterminée dans l'une des installations électriques aval :
i. ouverture (230) de l'interrupteur (30, 32, 34) de la ligne de sortie (18, 20, 22) dans laquelle la surcharge a été déterminée.

8. Procédé de fonctionnement selon la revendication 7, **caractérisé en ce qu'**un seuil de courant est défini pour chaque ligne de sortie (18, 20, 22), une surcharge dans l'une parmi les lignes de sortie (18, 20, 22) étant déterminée lorsque le signal représentatif du courant de sortie de cette ligne de sortie (18, 20, 22) correspond à un courant dont l'intensité dépasse le seuil de courant défini pour cette ligne de sortie (18, 20, 22).

9. Procédé de fonctionnement selon l'une quelconque des revendications 6 à 8, le dispositif de protection étant un dispositif de protection selon une combinaison des revendications 3 et 4, le procédé étant **caractérisé par** les étapes successives suivantes :
a. réception par l'unité de commande (50) d'un signal représentatif d'un courant différentiel provenant du dispositif de mesure de courant différentiel (39) ;
b. détermination (320) par l'unité de commande (50) si le signal représentatif du courant différentiel correspond à un départ différentiel intervenant dans une des installations électriques aval alimentées par l'une parmi les lignes de sortie (18, 20, 22) ;
c. lorsqu'un départ différentiel a été déterminé dans l'une des installations électriques aval :
i. ouverture (330) du dispositif de coupure électronique (40) ; et
ii. ouverture (340) des contacts électriques séparables (36).

10. Procédé de fonctionnement selon l'une quelconque des revendications 6 à 9, le dispositif de protection étant un dispositif de protection selon l'une quelconque des revendications 1 à 5, le procédé étant **caractérisé par** les étapes successives suivantes :
d. après l'ouverture du dispositif de coupure électronique (40) et l'ouverture de l'interrupteur (30, 32, 34) de chaque ligne de sortie (18, 20, 22) suite à la détermination par l'unité de commande (50) que le signal représentatif correspond à une tension inférieure à la tension minimale de bon fonctionnement du dispositif de coupure électronique, détermination par l'unité de commande (50) si le signal représentatif de la tension correspond à une tension supérieure à la tension minimale de bon fonctionnement du dispositif de coupure électronique (40) ;
e. lorsqu'une tension supérieure à la tension minimale de bon fonctionnement du dispositif de coupure électronique (40) a été déterminée :
i. fermeture du dispositif de coupure électronique (40) ; et
ii. fermeture de l'interrupteur (30, 32, 34) de chaque ligne de sortie (18, 20, 22).

11. Procédé de fonctionnement selon l'une quelconque des revendications 6 à 10, le dispositif de protection étant un dispositif de protection selon l'une quelconque des revendications 1 à 5, le procédé étant **caractérisé par** les étapes successives suivantes :
d. après l'ouverture du dispositif de coupure électronique (40) et l'ouverture de l'interrupteur (30, 32, 34) de chaque ligne de sortie (18, 20, 22) suite à la détermination par l'unité de commande (50) que le signal représentatif correspond à une tension supérieure à la tension maximale de bon fonctionnement du dispositif de coupure électronique, détermination par l'unité de commande (50) si le signal représentatif de la tension correspond à une tension inférieure à la tension maximale de bon fonctionnement du dispositif de coupure électronique (40) ;
e. lorsqu'une tension inférieure à la tension maximale de bon fonctionnement du dispositif de coupure électronique (40) a été déterminée :
i. fermeture du dispositif de coupure électronique (40) ; et
ii. fermeture de l'interrupteur (30, 32, 34) de chaque ligne de sortie (18, 20, 22).

12. Procédé de fonctionnement selon l'une quelconque des revendications 6 à 11, **caractérisé par** les étapes successives suivantes :
a. définition d'un seuil de courant de délestage ;
b. attribution d'un degré de priorité de chaque ligne de sortie (18, 20, 22) ;
c. lorsque la somme des courants de chaque ligne de sortie (18, 20, 22) correspondant au signal représentatif du courant de sortie de cette ligne dépasse le seuil de courant de délestage ou lorsque le courant d'entrée correspondant au signal représentatif du courant d'entrée dépasse le seuil de courant de délestage :
i. ouverture de l'interrupteur (30, 32, 34) de la ligne de sortie (18, 20, 22) à laquelle a été attribué le degré de priorité le plus faible parmi les degrés de priorités de chaque ligne de sortie (18, 20, 22).

## Patentansprüche

1. Schutzvorrichtung einer elektrischen Anlage, umfassend ein Paar Eingangsklemmen (12, 14), eine Eingangsleitung (16), die mit zwei Eingangsleitern (16L, 16N) versehen ist, wovon jeder mit einer der Eingangsklemmen (12, 14) verbunden ist, mindestens eine Ausgangsleitung (18, 20, 22), die an die Eingangsleitung (16) angeschlossen ist, versehen mit zwei Ausgangsleitern (18L, 18N, 20L, 20N, 22L, 22N) und die geeignet ist, eine nachgeschaltete elektrische Anlage zu speisen, eine elektronische Schaltvorrichtung (40), umfassend Leistungsschalter (42, 44) auf der Basis von Halbleiterkomponenten, die zwischen der Eingangsleitung (16) und der Ausgangsleitung (18, 20, 22) in Reihe angeschlossen sind, und eine Steuereinheit (50), die geeignet ist, um die elektronische Schaltvorrichtung (40) zu steuern, wobei die Schutzvorrichtung eine Vielzahl von Ausgangsleitungen (18, 20, 22) aufweist, die parallel zu der Eingangsleitung (16) angeschlossen sind, jede Ausgangsleitung (18, 20, 22) mit zwei Ausgangsleitern (18L, 18N, 20L, 20N, 22L, 22N), einer Ausgangsstrommessvorrichtung (24, 26, 28) versehen ist und geeignet ist, um eine nachgeschaltete elektrische Anlage zu speisen, wobei die Steuereinheit (50) ferner geeignet ist, um ein Signal zu empfangen, das repräsentativ für einen Ausgangsstrom jeder Ausgangsleitung (18, 20, 22) ist, der von der Ausgangsstrommessvorrichtung (24, 26, 28) dieser Ausgangsleitung (18, 20, 22) gemessen wird, und einer der Ausgangsleiter (18L, 18N, 20L, 20N, 22L, 22N) jeder Ausgangsleitung (18, 20, 22) mit einem Schalter (30, 32, 34) versehen ist, der von der Steuereinheit (50) steuerbar ist, um den Schalter (30, 32, 34) zwischen einer offenen Position und einer geschlossenen Position und umgekehrt zu schalten,
**dadurch gekennzeichnet, dass** die Eingangsleitung (16) mit einer Spannungsmessvorrichtung versehen ist,
wobei die Steuereinheit (50) ferner geeignet ist, um ein Signal zu empfangen, das repräsentativ für eine von der Spannungsmessvorrichtung gemessene Spannung ist ,
die Steuereinheit (50) konfiguriert ist, um zu bestimmen, ob das Signal, das repräsentativ für die Spannung ist, einer Spannung, die niedriger ist als eine Mindestspannung für den ordnungsgemäßen Betrieb der elektronischen Schaltvorrichtung (40) ist, oder einer Spannung, die höher ist als eine Maximalspannung für den ordnungsgemäßen Betrieb der elektronischen Schaltvorrichtung (40), entspricht,
und wobei die elektronische Schaltvorrichtung (40) und der Schalter (30, 32, 34) jeder Ausgangsleitung (18, 20, 22) konfiguriert sind, um zu öffnen, wenn eine Spannung unterhalb der Mindestspannung für den ordnungsgemäßen Betrieb der elektronischen Schaltvorrichtung (40) bestimmt wurde oder wenn eine Spannung oberhalb der maximalen Spannung für den ordnungsgemäßen Betrieb der elektronischen Schaltvorrichtung (40) bestimmt wurde.

2. Schutzvorrichtung nach Anspruch 1, **dadurch gekennzeichnet, dass** der Schalter (30, 32, 34) jeder Ausgangsleitung (18, 20, 22) aus einem Relais besteht, das von der Steuereinheit (50) steuerbar ist, um das Relais zwischen einer offenen und einer geschlossenen Stellung und umgekehrt zu schalten.

3. Schutzvorrichtung nach einem der Ansprüche 1 oder 2, **dadurch gekennzeichnet, dass** jeder Eingangsleiter (16L, 16N) trennbare elektrische Kontakte (36) umfasst, die zwischen dem Paar von Eingangsklemmen (12, 14) und der elektronischen Schaltvorrichtung (40) angeordnet sind, die Schutzvorrichtung ferner umfassend einen Aktuator, der von der Steuereinheit (50) steuerbar und geeignet ist, die trennbaren elektrischen Kontakte (36) zwischen einer geschlossenen Position und einer offenen Position und umgekehrt zu schalten.

4. Schutzvorrichtung nach einem der Ansprüche 1 bis 3, **dadurch gekennzeichnet, dass** die Eingangsleitung (16) mit einer Eingangsstrommessvorrichtung (38) und/oder einer Differenzstrommessvorrichtung (39) versehen ist, wobei die Steuereinheit (50) ferner geeignet ist, um ein Signal zu empfangen, das repräsentativ für einen Eingangsstrom ist, der von der Eingangsstrommessvorrichtung (38) gemessen wird, und/oder dazu geeignet ist, um ein Signal zu empfangen, das repräsentativ für einen Differenzstrom ist, der von der Differenzstrommessvorrichtung (39) gemessen wird.

5. Schutzvorrichtung nach einem der Ansprüche 1 bis 4, **dadurch gekennzeichnet, dass** die Steuereinheit (50) zu Folgendem konfiguriert ist:
- Empfangen, für jede Ausgangsleitung (18, 20, 22) eines Signals, das repräsentativ für einen Ausgangsstrom von der Ausgangsstrommessvorrichtung (24, 26, 28) der Ausgangsleitung (18, 20, 22) ist,
- Bestimmen (120), ob die Signale, die repräsentativ für den Ausgangsstrom jeder Ausgangsleitung (18, 20, 22) sind, einem Kurzschluss entsprechen, der in einer der nachgeschalteten elektrischen Anlagen auftritt, die von einer der Ausgangsleitungen (18, 20, 22) gespeist werden; und,
- wenn ein Kurzschluss in einer der nachgeschalteten elektrischen Anlagen bestimmt wurde:
∘ Übertragen (130) eines Öffnungsbefehls an die Steuerschaltung (46) der elektronischen Schaltvorrichtung (40), um die elektronische Schaltvorrichtung (40) zu öffnen (140),
∘ Befehlen des Öffnens (150) des Schalters (30, 32, 34) der Ausgangsleitung (18, 20, 22), in der der Kurzschluss bestimmt wurde, und
∘ - Befehlen des Schließens (160) der elektronischen Schaltvorrichtung (40).

6. Betriebsverfahren einer Schutzvorrichtung nach einem der Ansprüche 1 bis 5, umfassend die folgenden aufeinanderfolgenden Schritte:
a. Empfangen durch die Steuereinheit (50) für jede Ausgangsleitung (18, 20, 22) eines Signals, das repräsentativ für einen Ausgangsstrom ist, von der Ausgangsstrommessvorrichtung (24, 26, 28) der Ausgangsleitung (18, 20, 22);
b. Bestimmen (120) durch die Steuereinheit (50), ob die Signale, die repräsentativ für den Ausgangsstrom jeder Ausgangsleitung (18, 20, 22) sind, einem Kurzschluss entsprechen, der in einer der nachgeschalteten elektrischen Anlagen auftritt, die von einer der Ausgangsleitungen (18, 20, 22) gespeist werden;
c. wenn ein Kurzschluss in einer der nachgeschalteten elektrischen Anlagen bestimmt wurde:
i. Öffnen (140) der elektronischen Schaltvorrichtung (40);
ii. Öffnen (150) des Schalters (30, 32, 34) der Ausgangsleitung (18, 20, 22), in der der Kurzschluss bestimmt wurde; und
iii. Schließen (160) der elektronischen Schaltvorrichtung (40),
**dadurch gekennzeichnet, dass** es ferner die folgenden Schritte umfasst:
a. Empfangen, durch die Steuereinheit (50), eines Signals, das repräsentativ für eine Spannung von der Spannungsmessvorrichtung ist;
b. Bestimmen durch die Steuereinheit (50), ob das Signal, das repräsentativ für die Spannung ist, einer Spannung, die niedriger ist als eine Mindestspannung für den ordnungsgemäßen Betrieb der elektronischen Schaltvorrichtung (40), oder einer Spannung, die höher ist als eine Maximalspannung für den ordnungsgemäßen Betrieb der elektronischen Schaltvorrichtung (40), entspricht;
c. wenn eine Spannung, die niedriger ist als die Mindestspannung für den ordnungsgemäßen Betrieb des elektronischen Schaltgeräts (40), oder eine Spannung, die höher als die Maximalspannung für den ordnungsgemäßen Betrieb des elektronischen Schaltgeräts (40), bestimmt wurde:
i. Öffnen der elektronischen Schaltvorrichtung (40); und
ii. Öffnen des Schalters (30, 32, 34) jeder Ausgangsleitung (18, 20, 22).

7. Betriebsverfahren nach Anspruch 6, **gekennzeichnet durch** die folgenden aufeinanderfolgenden Schritte:
a. Bestimmen (220) durch die Steuereinheit (50), ob die Signale, die repräsentativ für den Ausgangsstrom jeder Ausgangsleitung (18, 20, 22) sind, einer Überlast entsprechen, die in einer der nachgeschalteten elektrischen Anlagen auftritt, die von einer der Ausgangsleitungen (18, 20, 22) gespeist werden;
b. wenn in einer der nachgeschalteten elektrischen Anlagen eine Überlast bestimmt wurde:
i. Öffnen (230) des Schalters (30, 32, 34) der Ausgangsleitung (18, 20, 22), in der die Überlast bestimmt wurde.

8. Betriebsverfahren nach Anspruch 7, **dadurch gekennzeichnet, dass** für jede Ausgangsleitung (18, 20, 22) ein Stromschwellenwert definiert wird, wobei eine Überlast in einer der Ausgangsleitungen (18, 20, 22) bestimmt wird, wenn das Signal, das repräsentativ für den Ausgangsstrom dieser Ausgangsleitung (18, 20, 22) ist, einem Strom entspricht, dessen Stärke den für diese Ausgangsleitung (18, 20, 22) definierten Stromschwellenwert übersteigt.

9. Betriebsverfahren nach einem der Ansprüche 6 bis 8, wobei die Schutzvorrichtung eine Schutzvorrichtung gemäß einer Kombination der Ansprüche 3 und 4 ist, wobei das Verfahren durch die folgenden aufeinanderfolgenden Schritte gekennzeichnet ist:
a. Empfangen eines Signals durch die Steuereinheit (50), das repräsentativ für einen Differenzstrom von der Differenzstrommessvorrichtung (39) ist;
b. Bestimmen (320) durch die Steuereinheit (50), ob das Signal, das den Differenzstrom darstellt, einem Differenzabgang entspricht, der in einer der nachgeschalteten elektrischen Installationen auftritt, die von einer der Ausgangsleitungen (18, 20, 22) gespeist werden;
c. wenn in einer der nachgeschalteten elektrischen Anlagen ein Differenzabgang bestimmt wurde:
i. Öffnen (330) der elektronischen Schaltvorrichtung (40); und
ii. Öffnen (340) der trennbaren elektrischen Kontakte (36).

10. Betriebsverfahren nach einem der Ansprüche 6 bis 9, wobei die Schutzvorrichtung eine Schutzvorrichtung nach einem der Ansprüche 1 bis 5 ist, wobei das Verfahren durch die folgenden aufeinanderfolgenden Schritte gekennzeichnet ist:
d. nach dem Öffnen der elektronischen Schaltvorrichtung (40) und dem Öffnen des Schalters (30, 32, 34) jeder Ausgangsleitung (18, 20, 22) nach dem Bestimmen durch die Steuereinheit (50), dass das repräsentative Signal einer Spannung entspricht, die niedriger ist als die Mindestspannung für den ordnungsgemäßen Betrieb der elektronischen Schaltvorrichtung, Bestimmen durch die Steuereinheit (50), ob das repräsentative Signal der Spannung einer Spannung entspricht, die höher ist als die Mindestspannung für den ordnungsgemäßen Betrieb der elektronischen Schaltvorrichtung (40);
e. wenn eine Spannung bestimmt wurde, die höher ist als die Mindestspannung für den ordnungsgemäßen Betrieb der elektronischen Schaltvorrichtung (40):
i. Schließen der elektronischen Schaltvorrichtung (40); und
ii. Schließen des Schalters (30, 32, 34) jeder Ausgangsleitung (18, 20, 22).

11. Betriebsverfahren nach einem der Ansprüche 6 bis 10, wobei die Schutzvorrichtung eine Schutzvorrichtung nach einem der Ansprüche 1 bis 5 ist, wobei das Verfahren durch die folgenden aufeinanderfolgenden Schritte gekennzeichnet ist:
d. nach dem Öffnen der elektronischen Schaltvorrichtung (40) und dem Öffnen des Schalters (30, 32, 34) jeder Ausgangsleitung (18, 20, 22) nach dem Bestimmen durch die Steuereinheit (50), dass das repräsentative Signal einer Spannung entspricht, die höher ist als die Maximalspannung für den ordnungsgemäßen Betrieb der elektronischen Schaltvorrichtung, Bestimmen durch die Steuereinheit (50), ob das repräsentative Signal der Spannung einer Spannung entspricht, die niedriger ist als die Maximalspannung für den ordnungsgemäßen Betrieb der elektronischen Schaltvorrichtung (40);
e. wenn eine Spannung bestimmt wurde, die niedriger ist als die Maximalspannung für den ordnungsgemäßen Betrieb der elektronischen Schaltvorrichtung (40):
i. Schließen der elektronischen Schaltvorrichtung (40); und
ii. Schließen des Schalters (30, 32, 34) jeder Ausgangsleitung (18, 20, 22).

12. Betriebsverfahren nach einem der Ansprüche 6 bis 11, **gekennzeichnet durch** die folgenden aufeinanderfolgenden Schritte:
a. Definition eines Schwellenwerts für Lastabwurfstrom;
b. Zuweisen eines Prioritätsgrads zu jeder Ausgabeleitung (18, 20, 22);
c. wenn die Summe der Ströme jeder Ausgangsleitung (18, 20, 22), die dem Signal entspricht, das repräsentativ für den Ausgangsstrom dieser Leitung ist, den Schwellenwert für Lastabwurfstrom überschreitet oder wenn der Eingangsstrom, der dem Signal entspricht, das repräsentativ für den Eingangsstrom, den Schwellenwert für Lastabwurfstrom überschreitet:
i. Öffnen des Schalters (30, 32, 34) jener Ausgangsleitung (18, 20, 22), der der niedrigste Prioritätsgrad unter den Prioritätsgraden jeder Ausgangsleitung (18, 20, 22) zugewiesen wurde.

## Claims

1. A device for protecting an electrical installation, comprising a pair of input terminals (12, 14), an input line (16) provided with two input conductors (16L, 16N) each connected to one of the input terminals (12, 14), at least one output line (18, 20, 22) connected to the input line (16), provided with two output conductors (18L, 18N, 20L, 20N, 22L, 22N) and able to supply a downstream electrical installation, an electronic breaking device (40) comprising power switches (42, 44) based on semiconductor components connected in series between the input line (16) and the output line (18, 20, 22), and a control unit (50) able to control the electronic breaking device (40), the protection device comprises a plurality of output lines (18, 20, 22) connected in parallel to the input line (16), each output line (18, 20, 22) being provided with two output conductors (18L, 18N, 20L, 20N, 22L, 22N), an output current measuring device (24, 26, 28) and being able to supply a downstream electrical installation, the control unit (50) also being able to receive a signal representative of an output current of each output line (18, 20, 22) measured by the output current measuring device (24, 26, 28) of this output line (18, 20, 22), and one of the output conductors (18L, 18N, 20L, 20N, 22L, 22N) of each output line (18, 20, 22) is provided with a switch (30, 32, 34) controllable by the control unit (50) to switch the switch (30, 32, 34) between an open position and a closed position and vice versa,
**characterised in that** the input line (16) is provided with a voltage measuring device, the control unit (50) also being able to receive a signal representative of a voltage measured by the voltage measuring device,
the control unit (50) is configured to determine whether the signal representative of the voltage corresponds to a voltage lower than a minimum correct operating voltage of the electronic switching device (40), or to a voltage higher than a maximum correct operating voltage of the electronic switching device (40),
and the electronic breaking device (40) and the switch (30, 32, 34) of each output line (18, 20, 22) are configured to open when a voltage lower than the minimum operating voltage of the electronic breaking device (40) has been determined or when a voltage higher than the maximum operating voltage of the electronic breaking device (40) has been determined.

2. The protection device according to claim 1, **characterised in that** the switch (30, 32, 34) of each output line (18, 20, 22) consists of a relay which can be controlled by the control unit (50) to switch the relay between an open position and a closed position and vice versa.

3. The protection device according to any one of claims 1 or 2, **characterised in that** each input conductor (16L, 16N) comprises separable electrical contacts (36) arranged between the pair of input terminals (12, 14) and the electronic breaking device (40), the protection device further comprising an actuator controllable by the control unit (50) and capable of switching the separable electrical contacts (36) between a closed position and an open position and vice versa.

4. The protection device according to any one of claims 1 to 3, **characterised in that** the input line (16) is provided with an input current measuring device (38) and/or a differential current measuring device (39), the control unit (50) being further adapted to receive a signal representative of an input current measured by the input current measuring device (38) and/or adapted to receive a signal representative of a differential current measured by the differential current measuring device (39).

5. The protection device according to any one of claims 1 to 4, **characterised in**
**that** the control unit (50) is configured to:
- receive, for each output line (18, 20, 22), a signal representative of an output current from the output current measuring device (24, 26, 28) of the output line (18, 20, 22),
- determine (120) whether the signals representative of the output current of each output line (18, 20, 22) correspond to a short-circuit occurring in one of the downstream electrical installations supplied by one of the output lines (18, 20, 22), and,
- when a short-circuit has been identified in one of the downstream electrical installations:
∘ transmit (130) an opening command to the control circuit (46) of the electronic switching device (40) to open (140) the electronic switching device (40),
∘ command the opening (150) of the switch (30, 32, 34) of the output line (18, 20, 22) in which the short-circuit has been determined, and
∘ - command the closing (160) of the electronic breaking device (40).

6. A method for operating a protection device according to any one of claims 1 to 5, comprising the following successive steps:
a. receiving, by the control unit (50), for each output line (18, 20, 22), of a signal representative of an output current from the output current measuring device (24, 26, 28) of the output line (18, 20, 22);
b. determining (120) by the control unit (50) whether the signals representing the output current of each output line (18, 20, 22) correspond to a short-circuit occurring in one of the downstream electrical installations supplied by one of the output lines (18, 20, 22);
c. when a short-circuit has been identified in one of the downstream electrical installations:
i. opening (140) the electronic breaking device (40);
ii. opening (150) the switch (30, 32, 34) of the output line (18, 20, 22) in which the short-circuit has been determined; and
iii. closing (160) the electronic breaking device (40),
**characterised in that** it further comprises the following steps:
a. the control unit (50) receives a signal representative of a voltage from the voltage measuring device;
b. determining, by the control unit (50), whether the signal representative of the voltage corresponds to a voltage below a minimum correct operating voltage of the electronic switching device (40) or to a voltage above a maximum correct operating voltage of the electronic switching device (40);
c. when a voltage lower than the minimum operating voltage of the electronic switching device (40), or a voltage higher than the maximum operating voltage of the electronic switching device (40) has been determined:
i. opening the electronic breaking device (40); and
ii. opening the switch (30, 32, 34) on each output line (18, 20, 22).

7. The method for operation according to claim 6, **characterised by** the following successive steps:
a. determining (220) by the control unit (50) whether the signals representing the output current of each output line (18, 20, 22) correspond to an overload occurring in one of the downstream electrical installations supplied by one of the output lines (18, 20, 22);
b. when an overload has been determined in one of the downstream electrical installations:
i. opening (230) the switch (30, 32, 34) of the output line (18, 20, 22) in which the overload has been determined.

8. The method for operation according to claim 7, **characterised in that** a current threshold is defined for each output line (18, 20, 22), an overload in one of the output lines (18, 20, 22) being determined when the signal representative of the output current of that output line (18, 20, 22) corresponds to a current whose intensity exceeds the current threshold defined for that output line (18, 20, 22).

9. The method for operation according to any one of claims 6 to 8, the protection device being a protection device according to a combination of claims 3 and 4, the method being **characterised by** the following successive steps:
a. reception by the control unit (50) of a signal representative of a differential current from the differential current measuring device (39);
b. determination (320) by the control unit (50) whether the signal representing the differential current corresponds to a differential fault occurring in one of the downstream electrical installations supplied by one of the output lines (18, 20, 22);
c. when a differential fault has been determined in one of the downstream electrical installations:
i. opening (330) the electronic breaking device (40); and
ii. opening (340) the separable electrical contacts (36).

10. The method of operation according to any one of claims 6 to 9, the protection device being a protection device according to any one of claims 1 to 5, the method being **characterised by** the following successive steps:
d. after opening the electronic breaking device (40) and opening the switch (30, 32, 34) of each output line (18, 20, 22) following determination by the control unit (50) that the representative signal corresponds to a voltage lower than the minimum correct operating voltage of the electronic breaking device, determining, by the control unit (50), if the signal representative of the voltage corresponds to a voltage higher than the minimum correct operating voltage of the electronic breaking device (40);
e. when a voltage higher than the minimum operating voltage of the electronic switching device (40) has been determined:
i. closing the electronic breaking device (40); and
ii. closing the switch (30, 32, 34) on each output line (18, 20, 22).

11. The method for operation according to any one of claims 6 to 10, the protection device being a protection device according to any one of claims 1 to 5, the method being **characterised by** the following successive steps:
d. after opening the electronic breaking device (40) and opening of the switch (30, 32, 34) of each output line (18, 20, 22) following determination by the control unit (50) that the representative signal corresponds to a voltage higher than the maximum correct operating voltage of the electronic breaking device, determining by the control unit (50) if the signal representative of the voltage corresponds to a voltage lower than the maximum correct operating voltage of the electronic breaking device (40);
e. when a voltage lower than the maximum operating voltage of the electronic switching device (40) has been determined:
i. closing the electronic breaking device (40); and
ii. closing the switch (30, 32, 34) on each output line (18, 20, 22).

12. A method for operation according to any one of claims 6 to 11, **characterised by** the following successive steps:
a. defining a load-shedding current threshold;
b. assigning a priority level to each output line (18, 20, 22);
c. when the sum of the currents of each output line (18, 20, 22) corresponding to the signal representative of the output current of this line exceeds the load-shedding current threshold or when the input current corresponding to the signal representative of the input current exceeds the load-shedding current threshold:
i. opening the switch (30, 32, 34) of the output line (18, 20, 22) which has been assigned the lowest priority level among the priority levels of each output line (18, 20, 22).
